# FASCICULE DE BREVET EUROPEEN

(11) **EP 0 525 266 B1**
(45) Date de publication et mention de la délivrance du brevet: **14.09.1994**
(21) Numéro de dépôt: 91402155.5
(22) Date de dépôt: 31.07.1991
(51) Int. Cl.: C23G 5/028, C11D 7/50

(54) **Composition à base de (N. perfluorobutyl)-éthylène pour le nettoyage de surfaces solides**
Zusammensetzung auf der Basis von N-Perfluorbutylethylen zum Reinigen von festen Oberflächen
Composition based on n-perfluorobutyl-ethylene for cleaning solid surfaces

(43) Date de publication de la demande: 03.02.1993
(73) Titulaire: ELF ATOCHEM S.A., 92800 Puteaux (FR)
(72) Inventeur: Desbiendras, Daniel, F-93430 Villetaneuse (FR); Martin, Jean-Jacques, F-92270 Bois-Colombes (FR); Michaud, Pascal, F-95210 Saint Gratien (FR)
(74) Mandataire: Leboulenger, Jean

(56) Documents cités:
- EP-A- 0 443 911
- US-A- 4 624 988
- US-A- 5 026 497

## Description

La présente invention concerne le domaine des hydrocarbures fluorés et chlorofluorés. Elle a plus particulièrement pour objet une nouvelle composition utilisable dans les applications de nettoyage et dégraissage de surfaces solides, en particulier dans le défluxage et le nettoyage à froid de circuits imprimés.

Le 1,1,2-trichloro-1,2,2-trifluoroéthane (connu dans le métier sous la désignation F113) est largement utilisé dans l'industrie pour le nettoyage et le dégraissage des surfaces solides. Outre son application en électronique au nettoyage des flux de soudure pour éliminer le flux décapant qui adhère aux circuits imprimés, on peut mentionner ses applications au dégraissage de pièces métalliques lourdes et au nettoyage de pièces mécaniques de haute qualité et de grande précision comme, par exemple, les gyroscopes et le matériel militaire ou aérospatial. Dans ses diverses applications, le F113 est le plus souvent associé à d'autres solvants organiques (par exemple le méthanol), de préférence sous forme de mélanges azéotropiques ou pseudo-azéotropiques qui ne démixent pas et qui, employés au reflux, ont sensiblement la même composition dans la phase vapeur que dans la phase liquide.

Cependant, le F113 fait partie des chlorofluorocarbures complètement halogénés qui sont actuellement suspectés d'attaquer ou de dégrader l'ozone stratosphérique.

Pour contribuer à résoudre ce problème, la présente invention propose de remplacer les compositions à base de F113 par une nouvelle composition à base de (n.perfluorobutyl)-éthylène. Ce composé (C₄F₉CH=CH₂) est totalement dépourvu d'effet destructeur vis-à-vis de l'ozone et présente des caractéristiques très proches de celles du F113.

| **Caractéristiques** | **F113** | **C₄F₉CH=CH₂** |
|---|---|---|
| Point d'ébullition (°C) | 47,6 | 59 |
| Tension superficielle à 25°C (mN.m⁻¹) | 19 | 13,3 |
| Densité à 20°C | 1,57 | 1,46 |
| Inflammabilité | néant | néant |
| Point éclair | néant | néant |
| Pouvoir solvant (IKB à 25°C) | 31 | 9 |
| Solubilité de l'eau (ppm) | 110 | 72 |
| O.D.P. (ozone-depletion potential) | 0,78 | 0 |

La demande antérieure non-prépubliée de brevet européen EP-A-443911 décrit des compositions à base de (n-perfluorobutyl)-éthylène contenant e.a. des alcools ou des éthers, ainsi que l'utilisation de ces compositions comme agents de nettoyage
La composition à utiliser selon l'invention comprend en poids de 80 à 97 % de (n.perfluorobutyl)-éthylène, de 0,5 à 20 % d'isopropyl éther et de 0 à 10 % d'isopropanol.

Lorsque la composition ne contient pas d'isopropanol, elle comprend de préférence 85 à 90 % de (n.perfluorobutyl)-éthylène et de 15 à 10 % d'isopropyl éther. Dans ce domaine, il existe un azéotrope dont la température d'ébullition est de 57,4°C à la pression atmosphérique normale (1,013 bar) et la composition selon l'invention a un comportement pseudo-azéotropique, c'est-à-dire que la composition des phases vapeur et liquide est sensiblement la même, ce qui est particulièrement avantageux pour les applications visées.

Une composition particulièrement préférée selon l'invention est celle qui comprend en poids 90 à 95 % de (n.perfluorobutyl)-éthylène, 1 à 3 % d'isopropyl éther et 4 à 7 % d'isopropanol. Dans ce domaine, il existe aussi un azéotrope dont la température d'ébullition est de 54,8°C à la pression atmosphérique normale. Cette composition ne présente pas de point éclair dans les conditions standard de détermination (norme ASTM-D 3828).

Les azéotropes (n.perfluorobutyl)-éthylène/isopropyl éther et (n.perfluorobutyl)-éthylène/isopropyl éther/isopropanol sont des azéotropes positifs puisque leurs points d'ébullition sont inférieurs à ceux des constituants purs (C₄F₉CH=CH₂ : 59°C ; isopropyl éther : 69°C ; isopropanol : 82°C).

Comme dans les compositions connues à base de F113, la composition selon l'invention peut être avantageusement stabilisée contre l'hydrolyse et/ou les attaques radicalaires susceptibles de survenir dans les processus de nettoyage, en y ajoutant un stabilisant usuel tel que, par exemple, un nitroalcane, de préférence le nitrométhane, la proportion de stabilisant pouvant aller de 0,01 à 5 % par rapport au poids total : (n.perfluorobutyl)-éthylène + isopropyl éther + isopropanol.

La composition selon l'invention peut être utilisée dans les mêmes applications et selon les mêmes techniques que les compositions antérieures à base de F113.

Les exemples suivants illustrent l'invention sans la limiter.

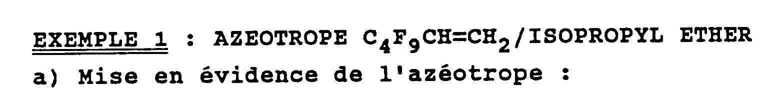

Dans le bouilleur d'une colonne à distiller (30 plateaux), on introduit 100 g d'isopropyl éther et 100 g de (n.perfluorobutyl)-éthylène. Le mélange est ensuite mis à reflux total pendant une heure pour amener le système à l'équilibre. Au palier de température, on prélève une fraction (environ 50 g) qu'on analyse par chromatographie en phase gazeuse.

L'examen des résultats, consignés dans le tableau suivant, indique la présence d'un azéotrope.

| | **COMPOSITION (% poids)** | |
|---|---|---|
| | C₄F₉CH=CH₂ | Isopropyl éther |
| Mélange initial | 50 | 50 |
| Fraction prélevée | 87,7 | 12,3 |

### b) Vérification de la composition azéotropique

Dans le bouilleur d'une colonne à distiller adiabatique (30 plateaux), on introduit 200 g d'un mélange contenant en poids 87,7 % de (n.perfluorobutyl)-éthylène et 12,3 % d'isopropyl éther. Le mélange est ensuite porté à reflux pendant une heure pour amener le système à l'équilibre, puis on soutire une fraction d'environ 50 g et on procède à son analyse par chromatographie en phase gazeuse ainsi qu'à celle du pied de distillation. Les résultats consignés dans le tableau suivant confirment la présence d'un azéotrope positif.

| | **COMPOSITION (% poids)** | |
|---|---|---|
| | C₄F₉CH=CH₂ | Isopropyl éther |
| Mélange initial | 87,7 | 12,3 |
| Fraction recueillie | 87,7 | 12,3 |
| Pied de distillation | 87,7 | 12,3 |
| Température d'ébullition corrigée pour 1,013 bar : 57,4°C | | |

Cet azéotrope, employé pour le nettoyage de flux de soudure ou en dégraissage de pièces mécaniques, donne de bons résultats.

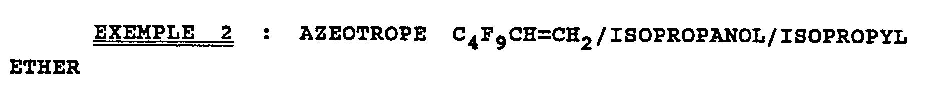

On opère comme à l'exemple 1-a à partir de 50 g d'isopropyl éther, 100 g de (n.perfluorobutyl)-éthylène et 50 g d'isopropanol. L'analyse CPG de la fraction prélevée montre qu'elle contient 93 % de (n.perfluorobutyl)-éthylène, 1,4 % d'isopropyl éther et 5,6 % d'isopropanol.

En opérant comme à l'exemple 1-b, on obtient les résultats consignés dans le tableau suivant qui confirment la présence d'un azéotrope positif C₄F₉CH=CH₂/isopropanol/isopropyl éther.

| | **COMPOSITION (% poids)** | | |
|---|---|---|---|
| | C₄F₉CH=CH₂ | Isopropanol | Isopropyl éther |
| Mélange initial | 93 | 5,6 | 1,4 |
| Fraction recueillie | 93 | 5,6 | 1,4 |
| Pied de distillation | 93 | 5,6 | 1,4 |
| Température d'ébullition corrigée pour 1,013 bar : 54,8°C. | | | |

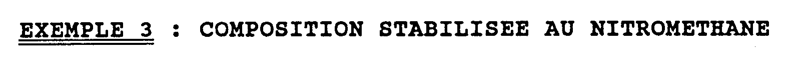

Dans une cuve de nettoyage à ultra-sons, on introduit 150 g d'un mélange contenant en poids 93 % de (n.perfluorobutyl)-éthylène, 1,4 % d'isopropyl éther, 5,5 % d'isopropanol et 0,1 % de nitrométhane comme stabilisant. Après avoir mis le système à reflux pendant une heure, on prélève un aliquat de la phase vapeur. Son analyse par chromatographie en phase gazeuse montre la présence de nitrométhane ce qui indique que le mélange est stabilisé dans la phase vapeur.

| | **COMPOSITION (% poids)** | | | |
|---|---|---|---|---|
| | C₄F₉CH=CH₂ | Isopropyl éther | Isopropanol | CH₃NO₂ |
| Mélange initial | 93 | 1,4 | 5,5 | 0,1 |
| Phase vapeur | 93 | 1,38 | 5,57 | 0,05 |

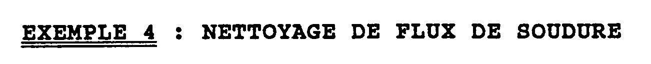

Dans la cuve d'une petite machine de nettoyage à ultrasons (BRANSON LTH 610-3) contenant de l'eau on installe un montage en Pyrex constitué d'un réceptacle conçu pour recevoir des circuits imprimés et surmonté d'un réfrigérant.

Dans ce réceptacle, on introduit 200 g de la composition azéotropique de l'exemple 2, puis on porte le mélange à la température d'ébullition.

Cinq circuits tests normalisés (modèle IPC-B-25), enduits de flux de soudure à base de colophane (flux R8F de la Société ALPHAMETAL) et recuits à l'étuve pendant 30 secondes à 220°C, sont immergés durant 3 minutes dans le liquide à l'ébullition sous ultra-sons, puis rincés dans la phase vapeur pendant 3 minutes.

Après séchage à l'air, la qualité du nettoyage est évaluée selon la procédure normalisée IPC 2.3.26 à l'aide d'un conductimètre de précision. La valeur obtenue, 2 µg/cm² éq. NaCl, est inférieure au seuil d'impureté toléré par la profession (2,5 µg/cm² éq. NaCl).

## Revendications

1. Composition comprenant en poids de 80 à 97 % de (n.perfluorobutyl)-éthylène, de 0,5 à 20 % d'isopropyl éther et de 0 à 10 % d'isopropanol.

2. Composition selon la revendication 1 contenant en poids de 85 à 90 % de (n.perfluorobutyl)-éthylène et de 15 à 10 % d'isopropyl éther.

3. Composition selon la revendication 2 sous forme d'azéotrope bouillant à 57,4°C à la pression normale.

4. Composition selon la revendication 1 contenant en poids 90 à 95 % de (n.perfluorobutyl)-éthylène, 1 à 3 % d'isopropyl éther, et 4 à 7 % d'isopropanol.

5. Composition selon la revendication 4 sous forme d'azéotrope bouillant à 54,8°C à la pression normale.

6. Composition selon l'une des revendications 1 à 5, comprenant en outre au moins un stabilisant.

7. Composition selon la revendication 6, dans laquelle le stabilisant est un nitroalcane, de préférence le nitrométhane.

8. Composition selon la revendication 6 ou 7, dans laquelle la proportion de stabilisant est de 0,01 à 5 % par rapport au poids total du mélange : (n.perfluorobutyl)-éthylène + isopropyl éther + isopropanol.

9. Application d'une composition selon l'une des revendications 1 à 8 au nettoyage des surfaces solides.

10. Application selon la revendication 9 au défluxage des circuits imprimés et au dégraissage des pièces mécaniques.

## Claims

1. Composition comprising by weight from 80 to 97 % of (n-perfluorobutyl)ethylene, from 0.5 to 20 % of isopropyl ether and from 0 to 10 % of isopropanol.

2. Composition according to Claim 1 containing by weight from 85 to 90 % of (n-perfluorobutyl)ethylene and from 15 to 10 % of isopropyl ether.

3. Composition according to Claim 2 in the form of an azeotrope boiling at 57.4°C at normal pressure.

4. Composition according to Claim 1 containing by weight 90 to 95 % of (n-perfluorobutyl)ethylene, 1 to 3 % of isopropyl ether and 4 to 7 % of isopropanol.

5. Composition according to Claim 4 in the form of an azeotrope boiling at 54.8°C at normal pressure.

6. Composition according to one of Claims 1 to 5, additionally comprising at least one stabilizing agent.

7. Composition according to Claim 6, in which the stabilizing agent is a nitroalkane, preferably nitromethane.

8. Composition according to Claim 6 or 7, in which the proportion of stabilizing agent is from 0.01 to 5 % relative to the total weight of the mixture: (n-perfluorobutyl)ethylene + isopropyl ether + isopropanol.

9. Application of a composition according to one of Claims 1 to 8 to the cleaning of solid surfaces.

10. Application according to Claim 9 for the defluxing of printed circuits and to the degreasing of mechanical components.

## Patentansprüche

1. Zusammensetzung, enthaltend 80 bis 97 Gew.% (n-perfluorbutyl)ethylen, 0,5 bis 20 Gew.% Isopropylether und 0 bis 10 Gew.% Isopropanol.

2. Zusammensetzung nach Anspruch 1, enthaltend 85 bis 90 Gew.% (n-Perfluorbutyl)ethylen und 15 bis 10 Gew.% Isopropylether.

3. Zusammensetzung nach Anspruch 2 in Form eines Azeotrops, das bei 57,4 °C unter normalem Druck siedet.

4. Zusammensetzung nach Anspruch 1, enthaltend 90 bis 95 Gew.% (n-Perfluorbutyl)ethylen, 1 bis 3 Gew.% Isopropylether und 4 bis 7 Gew.% Isopropanol.

5. Zusammensetzung nach Anspruch 4 in Form eines Azeotrops, das bei 54,8 °C unter Normaldruck siedet.

6. Zusammensetzung nach einem der Ansprüche 1 bis 5, die außerdem mindestens einen Stabilisator enthält.

7. Zusammensetzung nach Anspruch 6, in der der Stabilisator ein Nitroalkan, vorzugsweise Nitromethan ist.

8. Zusammensetzung nach Anspruch 6 oder 7, in der das Verhältnis von Stabilisator zum Gesamtgewicht der Mischung von (n-Perfluorbutyl)-ethylen, Isopropylether und Isopropanol 0,01 bis 5 % beträgt.

9. Verwendung einer Mischung nach einem der Ansprüche 1 bis 8 zum Reinigen von festen Oberflächen.

10. Verwendung nach Anspruch 9 zur Entfernung des Flußmittels bei gedruckten Schaltungen und zur Entfettung von mechanischen Teilen.
